Europäisches Patentamt

European Patent Office

Office européen des brevets

(11) Publication number : **0 493 989 A1**

# (12) EUROPEAN PATENT APPLICATION

(21) Application number : **91403256.0**

(22) Date of filing : **02.12.91**

(51) Int. Cl.⁵ : **H01L 27/118**

(30) Priority : **31.12.90 US 636177**

(43) Date of publication of application :
**08.07.92 Bulletin 92/28**

(84) Designated Contracting States :
**DE FR GB**

(71) Applicant : **International Business Machines
Corporation
Old Orchard Road
Armonk, N.Y. 10504 (US)**

(72) Inventor : **Vicary, Chet E.
35 Queen Anne Lane
Wappingers Falls, New York (US)**

Inventor : **Eckhardt, James P.
2555 North Arbor Trail
Marietta, California 30066 (US)**
Inventor : **English, George J.
14 Stuart Drive
Poughkeepsie, New York 12603 (US)**
Inventor : **Fuhrman, Daniel R.
19 Homer Place
Poughkeepsie, New York 12603 (US)**
Inventor : **Robortaccio, Rocco J.
R. R., Ridgeview Road
Hopewell Junction, New York 12533 (US)**

(74) Representative : **Tilliet, René Raymond Claude
et al
Cabinet Lavoix 2, Place d'Estienne d'Orves
F-75441 Paris Cédex 09 (FR)**

(54) Masterslice chip cell providing a plurality of logic types.

(57) Cell (1) for a masterslice chip providing three separate logic families comprises a plurality of discrete elements including current source (T9,T10) and emitter follower transistors (T11,T12), capacitors (C1,C2) and multitapped resistors (R1-R9), each connected to studs via corresponding contacts. Three channels are defined for wiring each cell to form differential cascode current switch, half current switch and current switch emitter follower logic. The cell also allows wiring to form converters to convert between logic families thereby allowing the masterslice chip any or all of the three logic families on the chip to optimize overall chip performance.

FIG. 1

The present invention relates generally to a masterslice chip for use in fabricating VLSI chips. More specifically, the present invention relates to a masterslice chip cell providing a plurality of logic types including differential cascode current switch, half current switch and current switch emitter follower logic. The cell advantageously can be configured to provide converter circuits for converting from one logic type to another logic type.

The masterslice design approach for producing a variety of VLSI semiconductor devices is well known to those of ordinary skill in the art. A first or common set of diffusion masks are used to produce an unpersonalized masterslice chip comprising a large number of identical unit cells. Each cell contains a variety of circuit elements which can be connected to form primitive logic elements. Personalization of the masterslice chip is then accomplished using a second set of masks to apply metalization layers for interconnecting the various elements within each cell and connecting two or more cells together.

Originally, masterslice chips were produced which employed only one type of logic. U.S. Patent No. 4,760, 289, for example, discloses a masterslice chip for implementing a number of circuits in differential cascode current switch (DCS) logic. U.S. Patent No. 4,742,383, on the other hand, discloses a cell for a masterslice chip formed from an array of field effect transistors, which can be operated at a variety of power levels.

Efforts to increase the density of cell components or improve the performance of logic elements formed from the devices in each cell have resulted in cells or groups of cells containing elements belonging to two logic families. U.S. Patent No. 4,737,644, for example, discloses forming DSC logic elements using emitter-coupled logic (ECL) current switches, while U.S. Patent No. 4,900,954 discloses the combination of current mode logic (CML) and ECL devices in a single region.

The principal object of the present invention is to provide a cell structure for a masterslice chip producing improved chip performance by allowing selection of the logic family of each individual cell on the chip. The present invention provides a cell structure compatible with three logic families and advantageously allows formation of converters to convert from one logic family type to another.

Another object of the present invention is to provide a cell structure having optimized paths for wiring used in connecting the discrete elements within the cell.

Still another object of the present invention is to provide a cell structure offering improved performance at costs comparable to previous cell structures.

These and other objects are provided in the present invention by a cell for a masterslice chip comprising a plurality of transistors, each having a base and an emitter coupled to a corresponding contact and at least two of the transistors having a common collector and one corresponding contact; a plurality of capacitors, and a plurality of resistors, each resistor having a plurality of contacts for providing a plurality of resistance values. Studs providing connection points for wiring are coupled to corresponding contacts of the transistors, capacitors and resistors. A plurality of channels defining horizontal and vertical wiring paths are disposed on the cell so as to permit forming a logical element of a logic family by interconnecting selected studs. Half current switch (HCS) logic, differential cascode current switch (DCS) logic and current switch emitter follower (CSEF) logic advantageously can be implemented in the cell.

These and other objects, features and advantages of the invention are disclosed in or apparent from the following description of preferred embodiments.

The preferred embodiment is described with reference to the drawings in which like elements are denoted throughout by like or similar numbers, and in which:

Fig. 1 is a diagram of an unwired masterslice cell according to the preferred embodiment of the present invention;

Fig. 2 is a diagram of a section of a masterslice chip containing a plurality of the cells illustrated in Fig. 1;

Fig. 3 is a schematic diagram of a first logic device implemented using DCS logic in a pair of the masterslice cells of Fig. 1;

Fig. 4 is an illustrative wiring diagram of circuit of Fig. 3 wired in a pair of masterslice cells of Fig. 1;

Fig. 5 is a schematic diagram of a second logic device implemented using CSEF logic in the masterslice cell of Fig. 1; and

Fig. 6 is an illustrative wiring diagram of the circuit of Fig. 5 wired in the masterslice cell of Fig. 1.

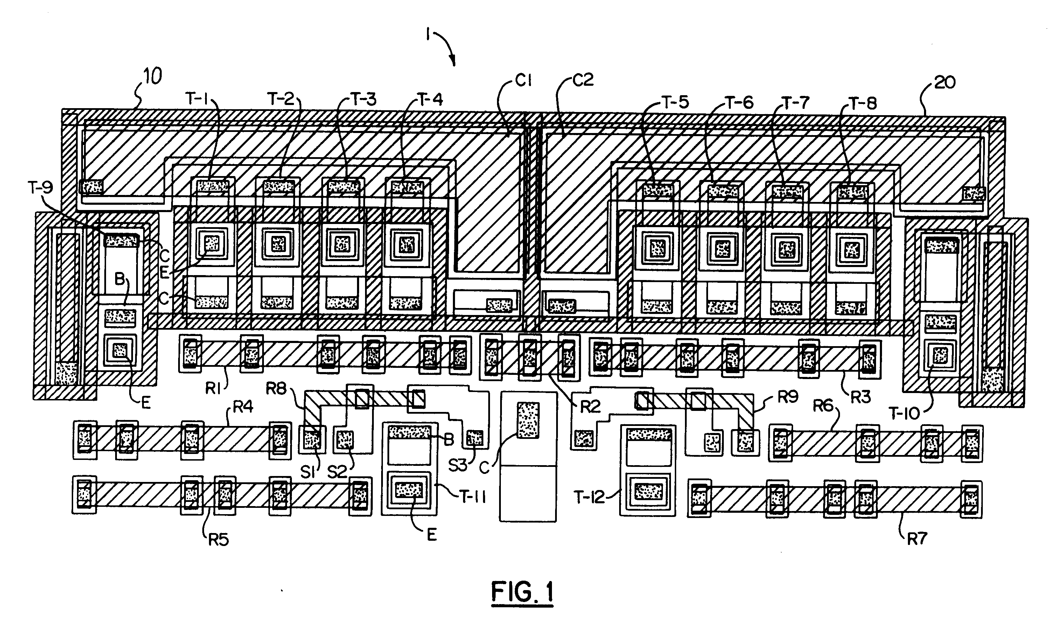

Fig. 1 illustrates the preferred embodiment according to the present invention of a cell 1, which is replicated in an array of identical cells forming a masterslice chip, having a substantially rectangular shape and comprising twelve transistors T-1 through T-12, nine resistors R-1 through R-9 and a pair of capacitors C-1 and C-2. The components comprising cell 1 are evenly divided between a left half cell 10 and a right half cell 20 with the odd resistor R-2 positioned so as to be common to both half cells 10 and 20. It will be appreciated that half cell 10 is the mirror image of half cell 20. A plurality of input/output (I/O) contacts surround the periphery of cell 1 and a single substrate contact SC is also provided.

Transistors T-1 through T-8 are input transistors with each of the transistors having a base, an emitter and a collector oriented in the vertical direction as viewed in Fig. 1. The bases, emitters and collectors of transistors T-1 through T-8 are each aligned substantially parallel to the horizontal axis of cell 1.

Transistors T-9 and T-10 are current source transistors located at opposing ends of cell 1 and having a vertical orientation similar to that of transistors T-1 through T-8. Transistors T-11 and T-12 are emitter follower transistors each having a base and an emitter opposing one another across the vertical axis of cell 1. Transistors T-11 and T-12 share a common collector located substantially on the vertical axis. Studs, discussed in detail below, corresponding to the base, emitter and collector of transistors T-1 through T-12 are generally denoted by letters B, E and C, respectively.

Resistors R-1 through R-7 are multitapped resistors located substantially parallel to the horizontal axis of cell 1. Preferably, resistors R-1 through R-7 are each formed from a first material having uniform resistivity and, most preferably, the first material has a resistivity of 450 Ohms per square. Resistors R-8 and R-9 are redundant resistors used primarily in DCS logic circuits. Preferably, resistors R-8 and R-9 are formed from a second material of uniform resistivity and, most preferably, the second material has a resistivity of 4,000 Ohms per square. It will be appreciated that each of the multitapped resistors R-1 through R-9 are capable of providing at least three separate resistance values according to the tap points on the resistor selected during wiring.

The capacitors C-1 and C-2 are back biased P-polysilicon-to-N-subcollector junctions. Preferably, the P-polysilicon is deposited over a P base material and is then covered with a contact, discussed below, in order to reduce the distributed resistance of capacitors C-1 and C-2.

Connection points for up to three metalization layers forming the interconnect wiring of the cell are provided by studs, generally denoted S, coupled to contacts for the various discrete elements described above. Referring to R-8 in Fig. 1, for example, three studs S1, S2 and S3 are shown connected to the three tap points on resistor R-8. Stud S1 is connected to a contact, shown in dashed lines, positioned directly over the left hand end of resistor R-8 while studs S2 and S3 are offset from the tap points of resistor R-8 by polysilicon conductor channels deposited in the cell in a conventional manner during cell fabrication. It will be appreciated that off-setting studs S2 and S3 allows placement of these studs in regions of cell 1 where the studs will not interfere with wiring. Similar stud offsets are provided throughout cell 1 to optimize wire placement, as discussed in greater detail below.

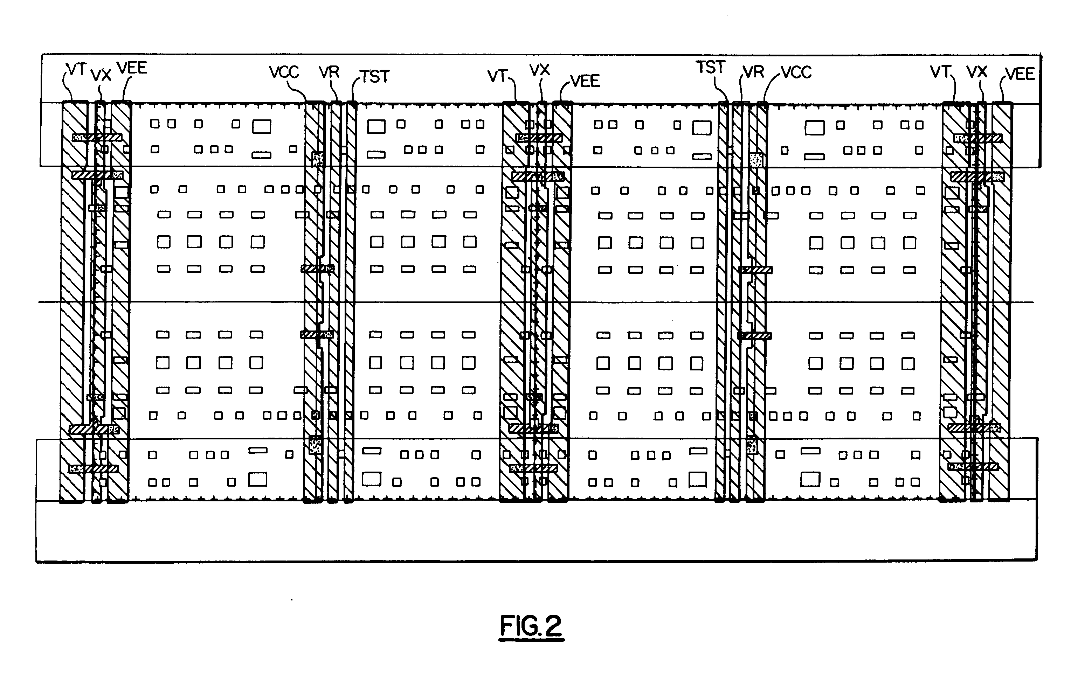

Referring to Fig. 2, four of the cells 1 are arranged in a rectangular array and are connected to one another through first, second and third level wiring. Horizontal and vertical channels are defined through which first, second and third level wiring, formed by applying metalization layers in a conventional manner, is run. Horizontal wiring channels are used for first level and third level wiring while vertical channels are used for second level wiring.

Three totally clear horizontal channels, one below resistors R-5 and R-7 and two above transistors T-1 through T-8 are advantageously provided for first level wiring. In addition, partial channels are provided, for example, between transistors T-1 through T-4 and R-1, R-1 and R-4 and R-4 and R-5. Similar partial channels are provided on half cell 20. One horizontal channel is provided on the base studs of transistors T-1 through T-8 to allow second level to first level vias to drop directly onto the T-1 through T-8 base studs so as not to block adjacent first level horizontal channels.

The second level wiring is advantageously used to provide voltage buses VT, VX, VEE, VCC, VR and TST in the vertical channels. Preferably, these voltages are distributed down to first level wiring for powering the individual cell 1 components.

It will be appreciated that cell 1 can be configured to provide conventional logic elements in the half current switch logic, differential cascode current switch logic and current switch emitter follower logic families. Cell I advantageously can be configured to provide logic-to-logic converter circuits, i.e., CSEF-to-DCS or DCS-to-CSEF logic converters, to match logic levels between cells in a masterslice chip.

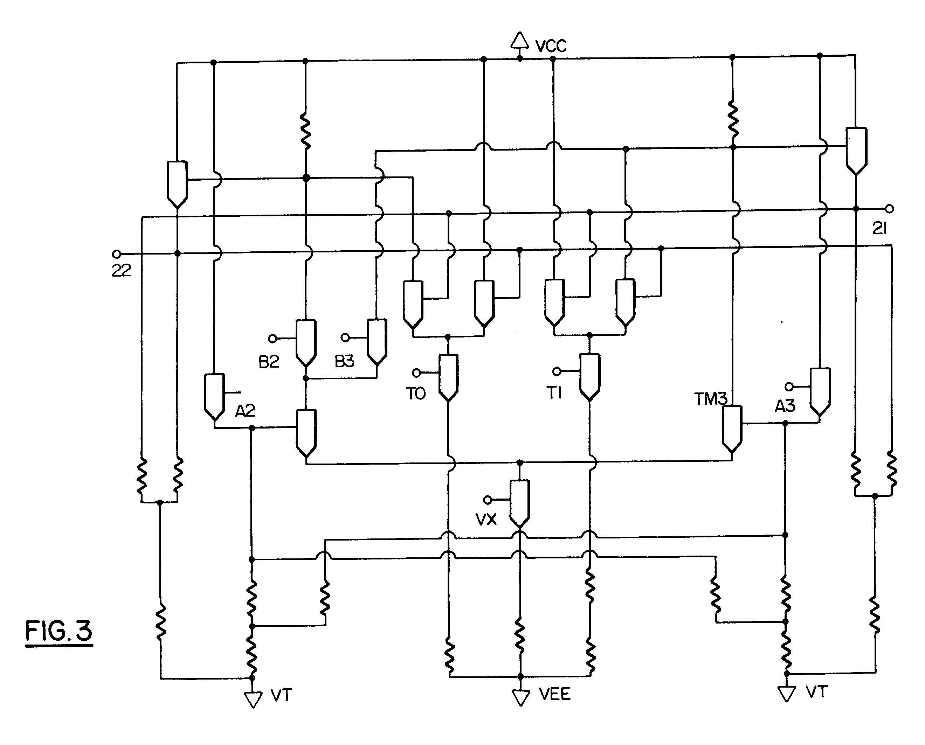

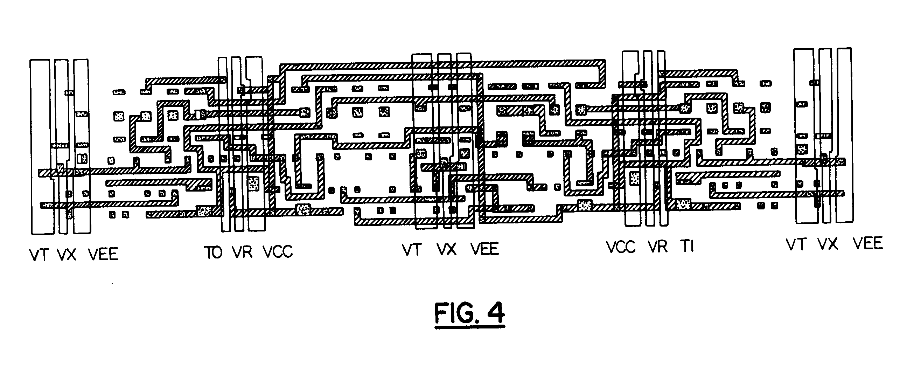

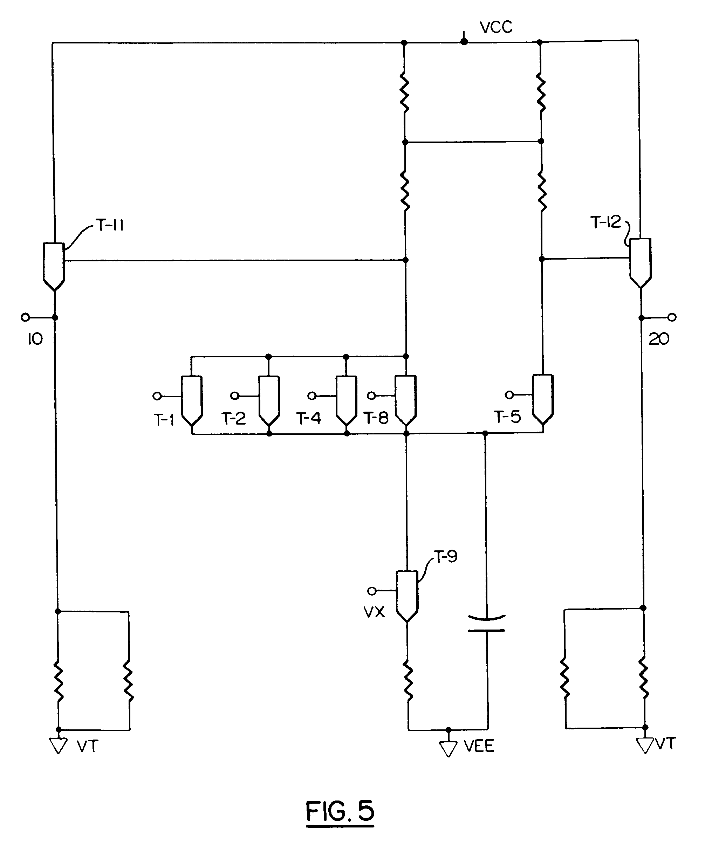

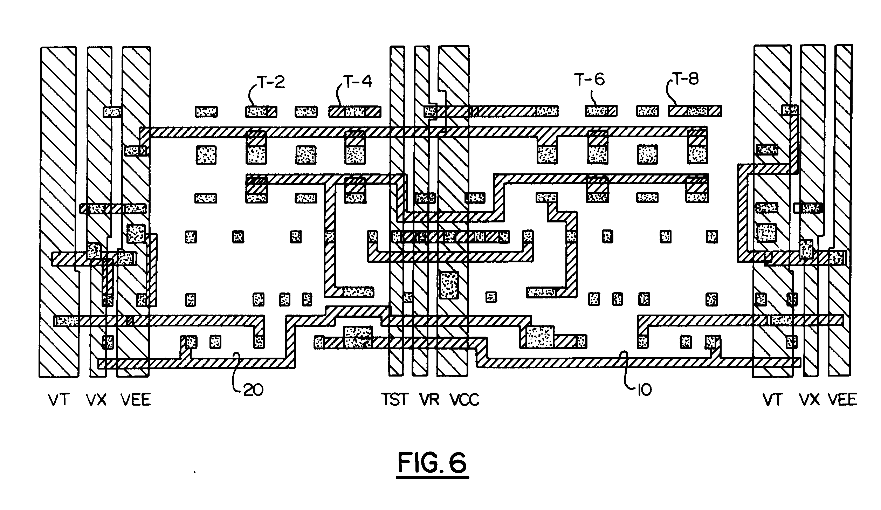

Referring to Figs. 3 and 4, an exemplary two way AND gate implemented using DCS logic is shown both schematically and in the form of wiring connections among the studs of a pair of masterslice cells 1, respectively. On the other hand, Figs. 5 and 6 show the schematic diagram and wiring connections to the various studs of cell 1, respectively, of a four way NOR gate implemented in conventional CSEF logic.

It will also be appreciated that the arrangement of cell 1 provides advantages over conventional cell arrangements. The inputs to transistors T-1 through T-8, for example are close to the top edge of cell 1, while the emitters of transistors T-11 and T-12 are near the bottom edge of cell 1, thus allowing flexibility for global wiring between cells.

Other modifications and variations to the invention will be apparent to those skilled in the art from the foregoing disclosure and teachings. Thus, while only certain embodiments of the invention have been specifically described herein, it will be apparent that numerous modifications may be made thereto without departing from the spirit and scope of the invention.

## Claims

1. Cell (1) for a masterslice chip, characterized in that it comprises:

a plurality of devices (T1-T12,R1-R9,C1,C2) disposed within said cell so as to permit formation of at least one logic element of a logic family, said logic family being selected from a group consisting of half current switch logic, differential cascode current switch logic and current switch emitter follower logic.

2. Cell (1) for a masterslice chip according to claim 1, characterized in that said plurality of devices comprises:

a plurality of transistors (T1-T2), each of said transistors having a base and an emitter coupled to a corresponding contact (B,E) and at least two (T11,T12) of said transistors having a common collector and one corresponding contact (C);

a plurality of capacitors (C1,C2), each of said capacitors having a pair of corresponding capacitor contacts;

a plurality of resistors (R1-R9), each of said resistors having a plurality of resistor contacts for providing a plurality of resistance values;

a plurality of studs coupled to corresponding contacts of said transistors, said capacitors and said resistors; and

a plurality of channels defining horizontal and vertical wiring paths disposed so as to permit forming a logical element of a logic family by interconnecting selected ones of said studs, wherein said logic family is selected from a group consisting of half current switch logic, differential cascode current switch logic and current switch emitter follower logic.

3. Cell (1) for a masterslice chip according to claim 2, characterized in that at least two (T11,T12) of said transistors are emitter follower transistors.

4. Cell (1) for a masterslice chip according to claim 2, characterized in that at least one (T9,T10) of said transistors is a current source transistor.

5. Cell (1) for a masterslice chip, according to claim 1, characterized in that it comprises :

a plurality of transistors (T1-T2), each of said transistors having a base and an emitter coupled to a corresponding contact (B,E) and at least two (T11,T12) of said transistors having a common collector and one corresponding contact (C);

a plurality of capacitors (C1,C2), each of said capacitors having a pair of corresponding capacitor contacts;

a plurality of resistors (R1-R9), each of said resistors having a plurality of resistor contacts for providing a plurality of resistance values;

a plurality of studs coupled to corresponding contacts of said transistors, said capacitors and said resistors; and

a plurality of channels defining horizontal and vertical wiring paths disposed so as to permit forming a logical element of a logic family by interconnecting selected ones of said studs, wherein said element is at least one of a logic element of a logic family, wherein said logic family is selected from a group consisting of half current switch logic, differential cascode current switch logic and current switch emitter follower logic, and a logic-to-logic converter circuit.

FIG. 1

EP 0 493 989 A1

FIG.2

FIG.3

FIG. 4

FIG. 5

## FIG.6

**European Patent Office**

## EUROPEAN SEARCH REPORT

Application Number

EP 91 40 3256

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IBM TECHNICAL DISCLOSURE BULLETIN. vol. 22, no. 7, December 1979, NEW YORK US pages 2775 - 2776; E. BERNDLMAIER ET AL.: 'Multi-circuit Masterslice' | 1 | H01L27/118 |
| Y | * page 2775, paragraph 1 - page 2776, last paragraph * * figures 1-2 * | 2-3,5 | |
| Y | US-A-3 577 038 (TEXAS INSTRUMENTS INC.) 4 May 1971 * column 2, line 37 - column 3, line 28; figures 1-5 * | 2-3,5 | |
| Y | IEEE JOURNAL OF SOLID-STATE CIRCUITS. vol. 14, no. 5, 5 October 1979, NEW YORK US pages 818 - 822; R.J. BLUMBERG: 'A 1500 Gate, Random Logic, Large-Scale Integrated (LSI) Masterslice' * page 820, left column, paragraph 2 - page 821, left column, paragraph 1 * * page 821, right column, paragraph 1 - page 822, left column, paragraph 1; figure 3 * | 2-3,5 | |

TECHNICAL FIELDS SEARCHED (Int. Cl.5)

H01L

The present search report has been drawn up for all claims

| Place of search | Date of completion of the search | Examiner |
|---|---|---|
| THE HAGUE | 07 APRIL 1992 | FRANSEN |

EPO FORM 1503 03.82 (P0401)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document